(19) 

Europäisches
Patentamt
European
Patent Office
Office européen
des brevets

(11) **EP 3 879 703 A1**

(12) **EUROPEAN PATENT APPLICATION**
published in accordance with Art. 153(4) EPC

(43) Date of publication:
**15.09.2021 Bulletin 2021/37**

(21) Application number: **19905668.0**

(22) Date of filing: **26.12.2019**

(51) Int Cl.:
***H03H 11/16*** (2006.01)

(86) International application number:
**PCT/CN2019/128780**

(87) International publication number:
**WO 2020/135612 (02.07.2020 Gazette 2020/27)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **26.12.2018 CN 201811605164**

(71) Applicant: **ZTE Corporation
shenzhen Guangdong 518057 (CN)**

(72) Inventor: **JIA, Chengwei
Shenzhen, Guangdong 518057 (CN)**

(74) Representative: **Zoli, Filippo
Brunacci & Partners S.r.l.
Via Pietro Giardini, 625
41125 Modena (IT)**

(54) **VECTOR SYNTHESIS PHASE SHIFTER AND VECTOR SYNTHESIS PHASE SHIFTING METHOD**

(57) The present document provides a vector synthesis phase shifter and a vector synthesis phase shifting method. The method comprises: adjusting a first reference input excitation by means of a first current source; determining a vector direction by means of a first vector direction control circuit, sending an input to a first gate width control Circuit, and generating, by means of an adjustment made by the first gate width control Circuit, a first output signal; adjusting a second reference input excitation by means of a second current source; determining a vector direction by means of a second vector direction control circuit, sending an input to a second gate width control circuit, and generating, by means of an adjustment made by the second gate width control circuit, a second output signal; and performing vector synthesis 0n the first output signal and the second output signal.

FIG. 3

EP 3 879 703 A1

**Description**

**CROSS-REFERENCE TO RELATED APPLICATION**

The present application claims the benefit of priority to Chinese Patent Application No. 201811605164.1 filed to China Patent Office on December 26, 2018, the disclosure of which is incorporated herein by reference in its entirety.

**TECHNICAL FIELD**

The present disclosure relates to the field of passive phase shifters, for example, to a vector sum phase shifter and a vector sum phase shifting method.

**BACKGROUND**

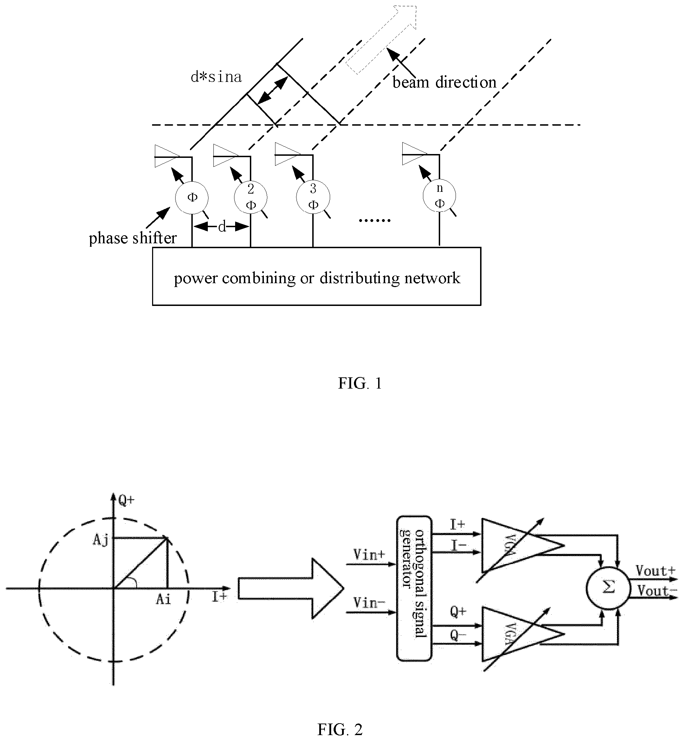

With the capabilities of beamforming and beam scanning, phased array technology can significantly improve the signal-to-noise ratio and sensitivity of wireless communication systems, and lower the power and noise requirements for individual channels in the systems. The phased array technology has been widely used in military and microwave and millimeter wave signal transmission with its superior characteristics, and has become one of the key technologies for millimeter wave communication in the 5th generation mobile communication (5G) technology. FIG. 1 shows a schematic diagram of a typical phased array system, where the beam can be steered and effective beamforming can be performed through the controllable phase difference between different channels. The implementations based on the phase difference between channels can be classified into radio frequency phase shifting, local oscillator phase shifting, intermediate frequency phase shifting, digital phase shifting, and the like. Digital phase shifting is realized purely in a digital domain, which has high requirements for the speed of digital processing and the processing algorithm and is relatively difficult to realize in high-speed communication. The mainstream phase shifting method is a hybrid phase shifting method that combines analog-domain phase shifting and digital-domain phase shifting. The key and difficult point in analog-domain phase shifting (RF phase shifting, local oscillator phase shifting, and intermediate frequency phase shifting) is the implementation of the phase shifter.

Common implementations of phase shifters are classified into passive phase shifters and active vector-sum phase shifters. The main disadvantages of the passive phase shifters include large insertion loss, large area, and small bandwidth. The active phase shifters based on the principle of vector sum use the amplification characteristics of active devices to superimpose orthogonal signals of different amplitudes to obtain the required phase, and therefore, the main advantages of the active phase shifters include a certain degree of signal gain and the ability to achieve arbitrary phase shifts within the range of 0-360 degrees.

As shown in FIG. 2, the vector sum active phase shifter divides the input signal $V_{in}$ into two channels with a phase difference of 90°. The signals of the two channels are weighted by amplitude $A_i$ and $A_j$, respectively, and then the weighted signals are summed to obtain the required output signal $V_{out}$, where, ideally, with no amplitude and phase errors:

$$V_{out} = (A_i + jA_j)V_{in}$$

The phase of the output signal is expressed as follows:

$$\phi = \arctan\left(\frac{A_j}{A_i}\right)$$

The amplitude of the output signal is expressed as follows:

$$A = \sqrt{A_i^2 + A_j^2}$$

The principle of vector sum phase shifters is simple. Because passive devices are rarely used, the circuit area is very small, the integration degree is higher, and a certain degree of gain can be obtained. The vector sum phase shifters have a simple working principle, and because of rarely using passive devices, the vector sum phase shifters have a very small circuit area and hence a higher degree of integration and can also obtain a certain degree of gain.

Because of the wide working frequency band of active devices, the vector-sum active phase shifter can obtain a wider working frequency band. Compared with passive devices, the main disadvantage of the active phase shifters is their relatively large power consumption.

## SUMMARY

The present application aims at solving at least one of the technical problems in the related art.

The present application provides a vector sum phase shifter and a vector sum phase shifting method to at least reduce the power consumption of the vector sum phase shifter.

In an embodiment, the present application provides a vector sum phase shifter, including: a first vector sum branch with an input end connected to a first reference input excitation, a second vector sum branch with an input end connected to a second reference input excitation, and a summer to which an output end of the first vector sum branch and an output end of the second vector sum branch are connected; the first vector sum branch including: a first current source, a first vector direction control circuit, and a first gate width control circuit; the first reference input excitation, after being adjusted by the first current source, passing through the first vector direction control circuit for vector direction determination, and then being output to the first gate width control circuit and then to the summer after being adjusted by the first gate width control circuit; the second vector sum branch including: a second current source, a second vector direction control circuit, and a second gate width control circuit; the second reference input excitation, after being adjusted by the second current source, passing through the second vector direction control circuit for vector direction determination, and then being output to the second gate width control circuit and then to the summer after being adjusted by the second gate width control circuit; and the summer vectorially summing an output signal from the first vector sum branch and an output signal from the second vector sum branch.

In an embodiment, the present application provides a vector sum phase shifting method, including: passing a first reference input excitation, after being adjusted by a first current source, through a first vector direction control circuit for vector direction determination and then to a first gate width control circuit for adjustment to generate a first output signal; passing a second reference input excitation, after being adjusted by a second current source, through a second vector direction control circuit for vector direction determination and then to a second gate width control circuit for adjustment to generate a second output signal; and vectorially summing the first output signal and the second output signal.

## BRIEF DESCRIPTION OF DRAWINGS

FIG. 1 is a schematic diagram of a typical phased array system;

FIG. 2 is a schematic diagram of a vector sum phase shifter;

FIG. 3 is a schematic diagram of the structure of a vector sum phase shifter according to an embodiment;

FIG. 4 is a schematic diagram of a circuit of a vector sum phase shifter in the related art;

FIG. 5 is a schematic diagram of a circuit of a vector sum phase shifter according to an embodiment;

FIG. 6 is a schematic diagram of a circuit of a current source according to an embodiment;

FIG. 7 is a schematic diagram of a circuit of a transistor array according to an embodiment; and

FIG. 8 is a flowchart of a vector sum phase shifting method according to an embodiment.

## DETAILED DESCRIPTION

The technical schemes of the present application will be described hereinafter with reference to the drawings and embodiments.

In an embodiment, if there is no conflict, the embodiments of the present application and the features in the embodiments can be combined with each other, and all the combinations fall within the scope of the present application. Moreover, although a logical order is shown in the flowcharts, the steps shown or described may be performed, in some cases, in a different order than shown or described herein.

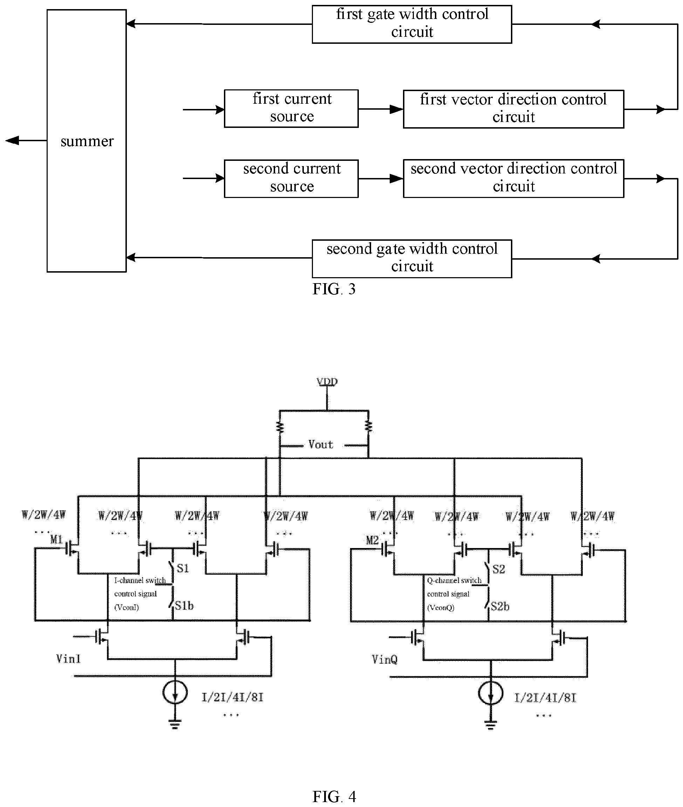

As shown in FIG. 3, this embodiment provides a vector sum phase shifter, including: a first vector sum branch with an input end connected to a first reference input excitation, a second vector sum branch with an input end connected to a second reference input excitation, and a summer to which an output end of the first vector sum branch and an output end of the second vector sum branch are connected;

the first vector sum branch including: a first current source, a first vector direction control circuit, and a first gate width control circuit;

the first reference input excitation, after being adjusted by the first current source, passing through the first vector direction control circuit for vector direction determination, and then being output to the first gate width control circuit and then to the summer after being adjusted by the first gate width control circuit;

the second vector sum branch including: a second current source, a second vector direction control circuit, and a second gate width control circuit;

the second reference input excitation, after being adjusted by the second current source, passing through the second vector direction control circuit for vector direction determination, and then being output to the second gate width control circuit and then to the summer after being adjusted by the second gate width control circuit; and

the summer vectorially summing an output signal from the first vector sum branch and an output signal from the second vector sum branch.

A schematic diagram of a circuit according to an embodiment of the present disclosure is shown in FIG. 4. A first reference input excitation VinI and a second reference input excitation VinQ pass through a first current source and a second current source, respectively, for control of the gains Ai and Aj of the first reference input excitation VinI and the second reference input excitation VinQ, respectively, then through a first vector direction control circuit and a second vector direction control circuit for selection of directions of the excitations, and then through a first gate width control circuit and a second gate width control circuit for control of the gains Ai and Aj of the first reference input excitation VinI and the second reference input excitation VinQ by changing gate width of transistors, and then enter a summer through two vector sum branches to form a final output signal.

According to the disclosure, the current source and amplifying transistor realize a two-stage gain control function, and the control word of the current source can be correspondingly reduced by using an M-bit control word of the amplifying transistor, so as to reduce the power consumption with the gain unchanged. For example, if the M-bit control word of the amplifying transistor is doubled, the control word of the current source can be reduced to 1/2 of the original, thus ensuring the gain unchanged. According to the disclosure, by adding one stage of an amplifying transistor with the adjustable M-bit control word, low power consumption can be achieved with the same gain. While ensuring that the gain of the phase shifter is kept unchanged, the power consumption of the vector summer is greatly reduced, the phase shift value also becomes less sensitive to circuit mismatch, and thus the phase shift accuracy of the phase shifter is improved.

According to an embodiment of the present disclosure, the first vector direction control circuit includes two control switches, only one of which is closed when the phase shifter works; and the second vector direction control circuit includes two control switches, only one of which is closed when the phase shifter works.

According to an embodiment of the present disclosure, the first reference input excitation is orthogonal to the second reference input excitation.

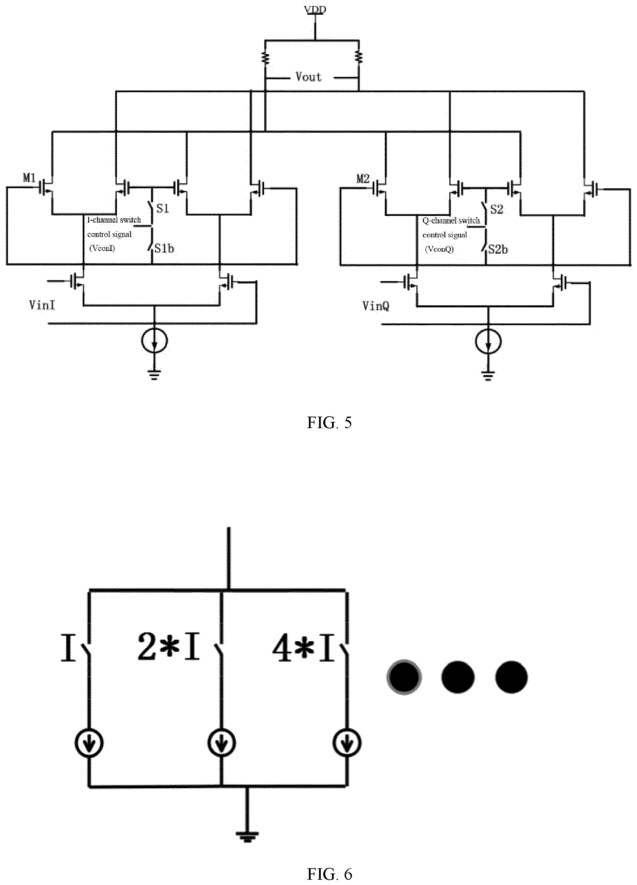

In the related art, the vector summer in the active phase shifter is a major contributing factor to the power consumption of an active phase shifter. The mainstream vector summer architecture is shown in FIG. 5. The circuit structure is composed of two Gilbert cells and some control switches.

The small signal voltage gain of this circuit is:

$$A_v = (g_{mI} + g_{mQ})R$$

$$= R\sqrt{\mu C_{ox}\frac{W_2}{L_2}} * \sqrt{(I_{SSI} + I_{SSQ})}$$

where $g_{mI}$ and $g_{mQ}$ represent the small signal current gains of I and Q channels, respectively, and R represents the equivalent load of the circuit; $\mu$ represents the carrier mobility, $C_{ox}$ represents the gate oxide thickness of the MOS transistor, W2 represents the gate width, $L_2$ represents the gate length, $I_{SSI}$ represents the total current of the I channel, and $I_{SSQ}$ represents the total current of the Q channel, so the phase of the output signal is:

$$\phi = \arctan(\frac{A_{vQ}}{A_{vI}}) = \arctan(\frac{g_{mQ}}{g_{mI}}) = \arctan(\sqrt{\frac{I_{SSQ}}{I_{SSI}}})$$

where $A_{VQ}$ represents the voltage gain of the Q channel and $A_{VI}$ represents the voltage gain of the I channel.

In the design of a signal summer, as long as the sum of the gains of the Gilbert cells of the two channels is a fixed value, the gain of the output signal can be kept unchanged with different phases, and the root mean square error of the gain of the circuit can be reduced, and outputs with different phases are realized by changing the ratio of the amplitudes of signals from the two channels.

For the Gilbert cell circuit driven by a tail current source as shown in FIG. 5, the gain of the output signal can be kept constant as long as $I_{SSI} + I_{SSQ} = C$ is set to a fixed value, and the phase of the output signal can be changed by adjusting the ratio of $I_{SSI}$ to $I_{SSQ}$.

Here, C is also the total working current of the entire vector summer. A large working current of the vector summer causes the entire phase shifter to consume a large amount of power. Because the number of channels in a phased array system is usually large, a large number of phase shifters would be required accordingly. Large power consumption of phase shifters will inevitably lead to a large increase in power consumption of the phased array.

A vector summer in an active phase shifter usually ensures a constant gain of the phase shifter by a constant total current of I and Q channels. There are two main problems in this method:

> 1. The difference between the maximum current and the minimum current of the two branches is relatively large, and it is difficult to achieve good matching in the circuit due to the large current difference, which leads to the decrease in phase shift accuracy.

> 2. The linearity requirement of the active phase shifter usually limits the minimum current value of the branch. For

$$\frac{1}{\tan^2(\frac{2*\pi}{2^N})}$$

an N-bit phase shifter, the ratio of the maximum current value to the minimum current value is , which also leads to the relatively large working current of the vector summer, and the larger the bit of the phase shifter N is, the greater the power consumption would be.

The embodiments of the present disclosure combine two approaches, i.e. the current control and the transistor gate width control, to ensure that the gain of the phase shifter is kept unchanged, greatly reduce the power consumption of the vector summer, and also reduces the difference between the maximum current and the minimum current of branches so that the phase shift value become less sensitive to circuit mismatch, thus improving the phase shift accuracy of the phase shifter.

According to an embodiment of the present disclosure, the first current source includes a plurality of current output circuits with the same or different current values, one or more of the plurality of current output circuits being used as a current source to output a current; and the second current source includes a plurality of current output circuits with the same or different current values, one or more of the plurality of current output circuits being used as a current source to output a current.

As shown in FIG. 6, the first current source includes a plurality of current output circuits with the same or different current values, one or more of the plurality of current output circuits being used as a current source to output a current; and the second current source includes a plurality of current output circuits with the same or different current values, one or more of the plurality of current output circuits being used as a current source to output a current.

The first gate width control circuit includes a first transistor array including two MOS transistor arrays arranged opposite each other, and the second gate width control circuit includes a second transistor array including two MOS transistor arrays arranged opposite each other.

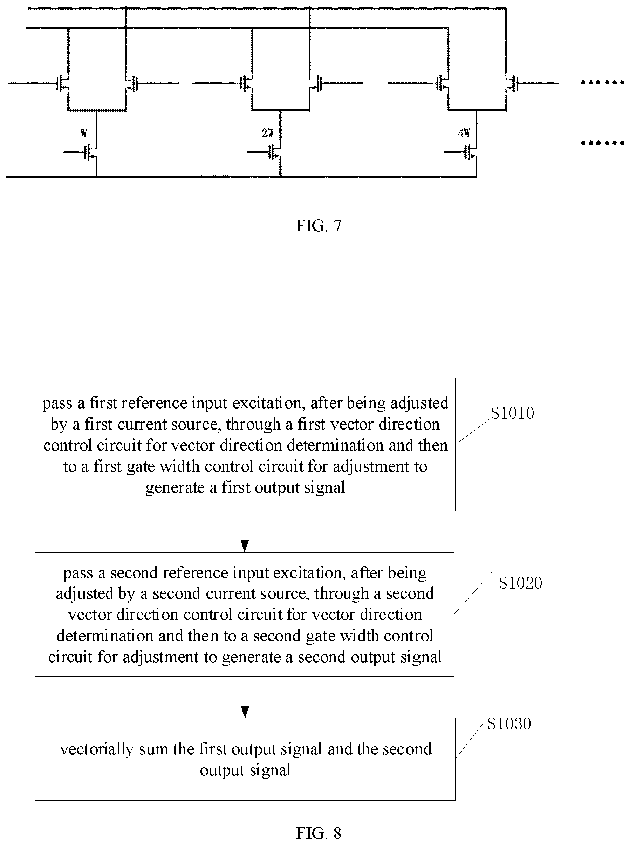

As shown in FIG. 7, according to an embodiment of the present disclosure, the MOS transistor array is a combination of MOS transistors based on a Gilbert structure and includes a plurality of MOS transistor arrays connected in series, each MOS transistor array including three P-type MOS transistors.

In each MOS transistor group, a source of a first P-type MOS transistor, a source of a second P-type MOS transistor, and a drain of a third P-type MOS transistor are connected together, a drain of the first P-type MOS transistor and drains of first P-type MOS transistors of other groups are connected together, a drain of the second P-type MOS transistor and drains of second P-type MOS transistors of other groups are connected together, a source of the third P-type MOS transistor and sources of third P-type MOS transistors of other groups are connected together, and gates of the plurality of MOS transistors are connected together.

In an embodiment, gates of the first P-type MOS transistor, the second P-type MOS transistor, and the third P-type MOS transistor in each group are connected together.

As shown in FIG. 8, an embodiment of the present disclosure also provides a vector sum phase shifting method, including the following steps.

At S1010, a first reference input excitation, after being adjusted by a first current source, is passed through a first vector direction control circuit for vector direction determination and then to a first gate width control circuit for adjustment to generate a first output signal.

At S1020, a second reference input excitation, after being adjusted by a second current source, is passed through a second vector direction control circuit for vector direction determination and then to a second gate width control circuit for adjustment to generate a second output signal.

At S 1030, the first output signal and the second output signal are vectorially summed.

## Embodiment I

This embodiment explains the working process of a vector sum phase shifter as follows:

As shown in FIG. 4, according to the present disclosure, not only the current source units of the I channel and the Q channel are divided into binary arrays, but also the amplifying transistors are divided into M-bit binary arrays. The power consumption of the entire vector summer can be reduced to $\dfrac{1}{2^{M-1}}$ of the original by the following control method:

Given that the I channel has a current of $I_1$ and an amplifying transistor $M_1$ with a width-to-length ratio of $\beta_1$, the Q channel has a current of $I_2$ and an amplifying transistor $M_2$ with a width-to-length ratio of $\beta_2$, and $I_1 \geq I_2$, $I_1 + I_2 = C$, then:

$$\begin{cases} \dfrac{C}{2} \leq I_1 \leq C \\[2mm] 0 \leq I_2 \leq \dfrac{C}{2} \end{cases}$$

$$I_1^a = \dfrac{I_1}{2^M}$$

1. The current $I_1$ is changed to                , and the gate width of the transistor $M_1$ is multiplied by $2^M$, that is, the width-to-length ratio is changed to $\beta_1^a = \beta_1 * 2^M$, then, ignoring the channel effect, the transconductance of the transistor $M_1$ after adjustment is expressed as:

$$g_{m1}^a = \sqrt{2 * K * \beta_1^a * I_1^a}$$

$$= \sqrt{2 * K * \beta_1 * 2^M * \dfrac{I_1}{2^M}}$$

$$= g_{m1}$$

where K represents $\mu * C_{ox}$.

It can be seen that the transconductance of the transistor $M_1$ remains unchanged after adjustment, but the I channel current becomes $\dfrac{1}{2^M}$ of the previous; and as $\dfrac{C}{2} \le I_1 \le C$, the I channel current after adjustment is no greater than $\dfrac{C}{2^M}$.

2. The current of the Q channel is adjusted based on conditions as follows:

$$
\begin{cases}
I_2^a = I_2 \,;\, \beta_2^a = \beta_2 \,(0 \le I_2 < \dfrac{C}{2^M}) \\[2mm]
I_2^a = \dfrac{I_2}{2} \,;\, \beta_2^a = 2 * \beta_2 \,(\dfrac{C}{2^M} \le I_2 < \dfrac{C}{2^{M-1}}) \\[2mm]
I_2^a = \dfrac{I_2}{4} \,;\, \beta_2^a = 4 * \beta_2 \,(\dfrac{C}{2^{M-1}} \le I_2 < \dfrac{C}{2^{M-2}}) \\[2mm]
\ldots \\[2mm]
I_2^a = \dfrac{I_2}{2^{M-1}} \,;\, \beta_2^a = 2^{M-1} * \beta_2 \,(\dfrac{C}{2^2} \le I_2 \le \dfrac{C}{2})
\end{cases}
$$

It can be seen that the transconductance of transistor $M_2$ remains unchanged after adjustment, but the current of the Q channel is no greater than $\dfrac{C}{2^M}$ after adjustment.

3. After the adjustment in steps 1 and 2, while keeping $g_{m1}$ and $g_{m2}$ unchanged, the total current of the circuit is:

$$C_{tot} = I_1^a + I_2^a$$

$$\le \dfrac{C}{2^M} + \dfrac{C}{2^M} = \dfrac{C}{2^{M-1}}$$

4. If 11 < 12, the adjustment may be made accordingly in the same way, and it can be seen that the power consumption of the entire vector summer is reduced to $\dfrac{1}{2^{M-1}}$ of the previous power consumption after adjustment. For an N-bit phase shifter, the ratio of maximum current to minimum current decreases from $\dfrac{1}{\tan^2(\dfrac{2*\pi}{2^N})}$ to $\dfrac{1}{2^M * \tan^2(\dfrac{2*\pi}{2^N})}$; and after adjustment, the matching of the circuit has also been effectively improved.

**Embodiment II**

Hereinafter, an example where M = 2 and N = 6 is taken to describe an implementation of the present disclosure. In an embodiment, M can be any integer value between 0 and N, which can be adjusted as required, assuming that the total current at the vector summer before adjustment is C.

The structure of a transistor $M_1$ is shown in FIG. 6. The corresponding relationship between phase shift value and gate width, power consumption, and total current according to a solution of the related art (before adjustment) is shown in Table 1. The corresponding relationship between phase shift value, gate width, power consumption, and total current according to the scheme of this embodiment (after adjustment) is shown in Table 2. The comparison between after-adjustment and before-adjustment is shown in Table 3. According to Table 3, the optimization of power consumption is obvious, and the ratio of maximum current to minimum current is greatly reduced, which reduces the requirement for circuit matching. In addition, the larger M is, the more the power consumption of the vector summer decreases, and accordingly, the smaller the ratio of maximum current to minimum current is.

Table 1

| Phase shift value | I channel current | Q channel current | I channel gate width | Q channel gate width | Total current at vector summer |
|---|---|---|---|---|---|
| 0 | C | 0 | $\beta_1$ | $\beta_2$ | C |
| 5.625 | 0.9904C | 0.0096C | $\beta_1$ | $\beta_2$ | C |
| 11.25 | 0.9619C | 0.0381C | $\beta_1$ | $\beta_2$ | C |
| 16.875 | 0.9157C | 0.0843C | $\beta_1$ | $\beta_2$ | C |
| 22.5 | 0.8536C | 0.1464C | $\beta_1$ | $\beta_2$ | C |
| 28.125 | 0.7778C | 0.2222C | $\beta_1$ | $\beta_2$ | C |
| 33.75 | 0.6913C | 0.3087C | $\beta_1$ | $\beta_2$ | C |
| 39.375 | 0.5975C | 0.4025C | $\beta_1$ | $\beta_2$ | C |
| 45 | 0.5C | 0.5C | $\beta_1$ | $\beta_2$ | C |
| 50.625 | 0.4025C | 0.5975C | $\beta_1$ | $\beta_2$ | C |
| 56.25 | 0.3087C | 0.6913C | $\beta_1$ | $\beta_2$ | C |
| 61.875 | 0.2222C | 0.7778C | $\beta_1$ | $\beta_2$ | C |
| 67.5 | 0.1464C | 0.8536C | $\beta_1$ | $\beta_2$ | C |
| 73.125 | 0.0843C | 0.9157C | $\beta_1$ | $\beta_2$ | C |
| 78.75 | 0.0381C | 0.9619C | $\beta_1$ | $\beta_2$ | C |
| 84.375 | 0.0096C | 0.9904C | $\beta_1$ | $\beta_2$ | C |
| 90 | 0 | C | $\beta_1$ | $\beta_2$ | C |

Table 2

| Phase shift value | I channel current | Q channel current | I channel gate width | Q channel gate width | Total current at vector summer |
|---|---|---|---|---|---|
| 0 | 0.25C | 0 | $4\beta_1$ | $\beta_2$ | 0.25C |
| 5.625 | 0.2476C | 0.0096C | $4\beta_1$ | $\beta_2$ | 0.2572C |
| 11.25 | 0.2405C | 0.0381C | $4\beta_1$ | $\beta_2$ | 0.2786C |
| 16.875 | 0.2289C | 0.0843C | $4\beta_1$ | $\beta_2$ | 0.3132C |
| 22.5 | 0.2134C | 0.1464C | $4\beta_1$ | $\beta_2$ | 0.3598C |
| 28.125 | 0.1945C | 0.2222C | $4\beta_1$ | $\beta_2$ | 0.4167C |
| 33.75 | 0.1728C | 0.1544C | $4\beta_1$ | $2\beta_2$ | 0.3272C |
| 39.375 | 0.1494C | 0.2013C | $4\beta_1$ | $2\beta_2$ | 0.3507C |
| 45 | 0.125C | 0.25C | $4\beta_1$ | $2\beta_2$ | 0.375C |
| 50.625 | 0.2013C | 0.1494C | $2\beta_1$ | $4\beta_2$ | 0.3507C |
| 56.25 | 0.1544C | 0.1728C | $2\beta_1$ | $4\beta_2$ | 0.3272C |
| 61.875 | 0.2222C | 0.1945C | $\beta_1$ | $4\beta_2$ | 0.4167C |
| 67.5 | 0.1464C | 0.2134C | $\beta_1$ | $4\beta_2$ | 0.3598C |

(continued)

| Phase shift value | I channel current | Q channel current | I channel gate width | Q channel gate width | Total current at vector summer |
|---|---|---|---|---|---|
| 73.125 | 0.0843C | 0.2289C | $\beta_1$ | $4\beta_2$ | 0.3132C |
| 78.75 | 0.0381C | 0.2405C | $\beta_1$ | $4\beta_2$ | 0.2786C |
| 84.375 | 0.0096C | 0.2476C | $\beta_1$ | $4\beta_2$ | 0.2572C |
| 90 | 0 | 0.25C | $\beta_1$ | $4\beta_2$ | 0.25C |

Table 3

| | Total current | Ratio of maximum current to minimum current |
|---|---|---|
| Mainstream design (before adjustment) | C | 103 |
| Design of the present disclosure M=2 (after adjustment) | <0.4167C | 26 |
| Design of the present disclosure M=3 (after adjustment) | <0.1988C | 13 |
| Design of the present disclosure M=4 (after adjustment) | <0.0982C | 6.5 |
| Design of the present disclosure M=5 (after adjustment) | <0.0406C | 3.3 |

**Claims**

1. A vector sum phase shifter, comprising:

   a first vector sum branch with an input end connected to a first reference input excitation;
   a second vector sum branch with an input end connected to a second reference input excitation; and
   a summer to which both an output end of the first vector sum branch and an output end of the second vector sum branch are connected;
   wherein the first vector sum branch comprises: a first current source, a first vector direction control circuit, and a first gate width control circuit;
   wherein the first reference input excitation, after being adjusted by the first current source, passes through the first vector direction control circuit for vector direction determination and is output to the first gate width control circuit, and then to the summer after being adjusted by the first gate width control circuit;
   wherein the second vector sum branch comprises: a second current source, a second vector direction control circuit, and a second gate width control circuit;
   wherein the second reference input excitation, after being adjusted by the second current source, passes through the second vector direction control circuit for vector direction determination and is output to the second gate width control circuit and then to the summer after being adjusted by the second gate width control circuit; and
   wherein the summer vectorially sums an output signal from the first vector sum branch and an output signal from the second vector sum branch.

2. The phase shifter of claim 1, wherein the first vector direction control circuit comprises two control switches, only one of which is closed when the phase shifter works; and the second vector direction control circuit comprises two control switches, only one of which is closed when the phase shifter works.

3. The phase shifter of claim 1, wherein the first reference input excitation is orthogonal to the second reference input excitation.

4. The phase shifter of claim 1, wherein the first current source comprises a plurality of current output circuits with same or different current values, and one or more of the plurality of current output circuits is used as a current source to output a current; and the second current source comprises a plurality of current output circuits with same or different current values, and one or more of the plurality of current output circuits is used as a current source to output a current.

5. The phase shifter of claim 1, wherein the first gate width control circuit comprises a first transistor array comprising two MOS transistor arrays arranged opposite each other; and the second gate width control circuit comprises a second transistor array comprising two MOS transistor arrays arranged opposite each other.

6. The phase shifter of claim 5, wherein each of the MOS transistor arrays is a combination of MOS transistors based on a Gilbert structure.

7. The phase shifter of claim 5, wherein,

the MOS transistor arrays each comprises a plurality of MOS transistor groups connected in series, each MOS transistor group comprises three P-type MOS transistors comprising a first P-type MOS transistor, a second P-type MOS transistor, and a third P-type MOS transistor; and
in each MOS transistor group, a source of the first P-type MOS transistor, a source of the second P-type MOS transistor, and a drain of the third P-type MOS transistor are connected together, a drain of the first P-type MOS transistor and drains of the first P-type MOS transistors of groups other than a current group are connected together, a drain of the second P-type MOS transistor and drains of the second P-type MOS transistors of groups other than a current group are connected together, a source of the third P-type MOS transistor and sources of the third P-type MOS transistors of groups other than a current group are connected together, and gates of the first P-type MOS transistor, the second P-type MOS transistor, and the third P-type MOS transistor in each group are connected together.

8. A vector sum phase shifting method, comprising:

passing a first reference input excitation, after being adjusted by a first current source, through a first vector direction control circuit for vector direction determination and then to a first gate width control circuit for adjustment to generate a first output signal;
passing a second reference input excitation, after being adjusted by a second current source, through a second vector direction control circuit for vector direction determination and then to a second gate width control circuit for adjustment to generate a second output signal; and
vectorially summing the first output signal and the second output signal.

FIG. 1

FIG. 2

first gate width control circuit

summer

first current source → first vector direction control circuit

second current source → second vector direction control circuit

second gate width control circuit

FIG. 3

VDD

Vout

W/2W/4W · · · M1  W/2W/4W · · ·  W/2W/4W · · ·  W/2W/4W · · ·  W/2W/4W · · · M2  W/2W/4W · · ·  W/2W/4W · · ·  W/2W/4W · · ·

S1
I-channel switch control signal (VconI) S1b

S2
Q-channel switch control signal (VconQ) S2b

VinI

VinQ

I/2I/4I/8I · · ·

I/2I/4I/8I · · ·

FIG. 4

FIG. 5

FIG. 6

FIG. 7

pass a first reference input excitation, after being adjusted by a first current source, through a first vector direction control circuit for vector direction determination and then to a first gate width control circuit for adjustment to generate a first output signal — S1010

pass a second reference input excitation, after being adjusted by a second current source, through a second vector direction control circuit for vector direction determination and then to a second gate width control circuit for adjustment to generate a second output signal — S1020

vectorially sum the first output signal and the second output signal — S1030

FIG. 8

## INTERNATIONAL SEARCH REPORT

| International application No. |
|---|
| **PCT/CN2019/128780** |

**A.    CLASSIFICATION OF SUBJECT MATTER**

   H03H 11/16(2006.01)i

According to International Patent Classification (IPC) or to both national classification and IPC

**B.    FIELDS SEARCHED**

Minimum documentation searched (classification system followed by classification symbols)

   H03H

Documentation searched other than minimum documentation to the extent that such documents are included in the fields searched

Electronic data base consulted during the international search (name of data base and, where practicable, search terms used)

   WPI, EPODOC, CNPAT, CNKI: 移相器, 矢量, 合成, MOS管, 栅宽, 控制, 电流, 调节, 方向, phase shifter, vector, synthesizer, gate, width, current, adjust, control, direction

**C.    DOCUMENTS CONSIDERED TO BE RELEVANT**

| Category* | Citation of document, with indication, where appropriate, of the relevant passages | Relevant to claim No. |
|---|---|---|
| A | CN 208272939 U (PINGHU AOTE MOXING ELECTRONIC CO., LTD.) 21 December 2018 (2018-12-21) <br>    description, paragraphs 0049-0058 | 1-8 |
| A | CN 107707217 A (XIDIAN UNIVERSITY) 16 February 2018 (2018-02-16) <br>    entire document | 1-8 |
| A | CN 106656099 A (HUAWEI TECHNOLOGIES CO., LTD.) 10 May 2017 (2017-05-10) <br>    entire document | 1-8 |
| A | US 2012062286 A1 (TEXAS INSTRUMENTS INCORPORATED) 15 March 2012 (2012-03-15) <br>    entire document | 1-8 |

☐ Further documents are listed in the continuation of Box C.        ☑ See patent family annex.

| *    Special categories of cited documents: | "T"    later document published after the international filing date or priority date and not in conflict with the application but cited to understand the principle or theory underlying the invention |
|---|---|
| "A"    document defining the general state of the art which is not considered to be of particular relevance | |
| "E"    earlier application or patent but published on or after the international filing date | "X"    document of particular relevance; the claimed invention cannot be considered novel or cannot be considered to involve an inventive step when the document is taken alone |
| "L"    document which may throw doubts on priority claim(s) or which is cited to establish the publication date of another citation or other special reason (as specified) | "Y"    document of particular relevance; the claimed invention cannot be considered to involve an inventive step when the document is combined with one or more other such documents, such combination being obvious to a person skilled in the art |
| "O"    document referring to an oral disclosure, use, exhibition or other means | |
| "P"    document published prior to the international filing date but later than the priority date claimed | "&"    document member of the same patent family |

| Date of the actual completion of the international search | Date of mailing of the international search report |
|---|---|
| **13 March 2020** | **27 March 2020** |

| Name and mailing address of the ISA/CN | Authorized officer |
|---|---|
| **China National Intellectual Property Administration** <br> **No. 6, Xitucheng Road, Jimenqiao Haidian District, Beijing 100088** <br> **China** | |
| Facsimile No. **(86-10)62019451** | Telephone No. |

Form PCT/ISA/210 (second sheet) (January 2015)

# EP 3 879 703 A1

**INTERNATIONAL SEARCH REPORT**
Information on patent family members

| Patent document cited in search report | | | Publication date (day/month/year) | Patent family member(s) | | | Publication date (day/month/year) |
|---|---|---|---|---|---|---|---|
| CN | 208272939 | U | 21 December 2018 | CN | 110048692 | A | 23 July 2019 |
| CN | 107707217 | A | 16 February 2018 | | None | | |
| CN | 106656099 | A | 10 May 2017 | KR | 20180056410 | A | 28 May 2018 |
| | | | | US | 2018145660 | A1 | 24 May 2018 |
| | | | | EP | 3324541 | A1 | 23 May 2018 |
| | | | | CN | 106656099 | B | 03 January 2020 |
| | | | | US | 10128817 | B2 | 13 November 2018 |
| US | 2012062286 | A1 | 15 March 2012 | JP | 2013543111 | A | 28 November 2013 |
| | | | | WO | 2012033509 | A1 | 15 March 2012 |
| | | | | JP | 5781162 | B2 | 16 September 2015 |
| | | | | CN | 103080768 | B | 03 December 2014 |
| | | | | CN | 103080768 | A | 01 May 2013 |
| | | | | US | 8472884 | B2 | 25 June 2013 |

Form PCT/ISA/210 (patent family annex) (January 2015)

**REFERENCES CITED IN THE DESCRIPTION**

**Patent documents cited in the description**

- CN 201811605164